Europäisches Patentamt

European Patent Office

Office européen des brevets

(19)

(11) EP 0 616 470 B1

(12) **EUROPÄISCHE PATENTSCHRIFT**

(45) Veröffentlichungstag und Bekanntmachung des Hinweises auf die Patenterteilung:
**04.08.1999 Patentblatt 1999/31**

(51) Int Cl.6: **H04N 7/24**

(21) Anmeldenummer: **94103025.6**

(22) Anmeldetag: **01.03.1994**

(54) **System zur Übertragung und Vorrichtung zum Empfang von digitalen Fernsehsignalen**

Transmission system and apparatus for receiving digital television signals

Système de transmission et dispositif pour la réception de signaux de télévision numérique

(84) Benannte Vertragsstaaten:
**AT BE CH DE ES FR GB IT LI**

(30) Priorität: **13.03.1993 DE 4308094**

(43) Veröffentlichungstag der Anmeldung:
**21.09.1994 Patentblatt 1994/38**

(73) Patentinhaber: **GRUNDIG Aktiengesellschaft 90762 Fürth (DE)**

(72) Erfinder: **Kays, Rüdiger, Dr.**
**D-90748 Fürth (DE)**

(56) Entgegenhaltungen:
**EP-A- 0 465 428**  **EP-A- 0 524 625**
**GB-A- 2 088 676**

- **PROCEEDINGS OF THE IEEE, Bd.78, Nr.7, Juli 1990, NEW YORK US Seiten 1250 - 1266 YUEN ET AL 'modulation and coding for satellite and space communications'**

**Beschreibung**

Die Erfindung betrifft ein System zur Übertragung und eine Vorrichtung zum Empfang von digitalen Fernsehsignalen.

Bei der digitalen Übertragung von Daten, insbesondere bei der Übertragung von digitalisierten und gegebenenfalls quellencodierten TV-Bilddaten, werden hocheffiziente Modulationsverfahren zur optimalen Nutzung des Kanals in Betracht gezogen. Durch geschickte Kombination von Kanalcodierung und Kanalmodulation können auf herkömmlichen terrestrischen Fernsehkanälen Übertragungseffizienzen von über 5 Bit/Sek/Hz erzielt werden. Als Modulationsverfahren kommen dabei

- breitbandige Modulationsverfahren mit einem oder wenigen (z.B. 3) Trägern in einem 8 MHz-Kanal und entsprechend breitbandiger Modulation oder

- Verfahren mit einer Vielzahl von Trägern, beispielsweise 2048, in Frage.

Bei letzteren werden insbesondere dem OFDM-Verfahren, welches unter anderem in der Zeitschrift Fernseh- und Kino-Technik, 46. Jg., Nr. 9/1992, S. 559-570, beschrieben ist, gute Realisierungschancen eingeräumt.

Um die oben erwähnte hohe Effizienz zu erzielen, werden Modulationstechniken wie 16 PSK, 16 QAM, 32 QAM oder 64 QAM vorgesehen. Bei 64 QAM ist die theoretische Grenze der Bandbreiteneffizienz 6 Bit/Sek/Hz. Diese Grenze wird in der Praxis nicht erreicht, weil nicht die volle Kanalbandbreite nutzbar ist, sondern vielmehr im Bereich der Bandgrenzen Filterflanken die Kapazität begrenzen. Ferner treten bei realistischen Kanälen stets einzelne Bitfehler auf, die z.B. durch weißes Rauschen, aber auch Fremdstörer (Manmade noise) verursacht werden.

Um die Qualität der Übertragung unter praktischen Bedingungen sicherstellen zu können, wird eine Kanalcodierung eingefügt. Hierbei werden senderseitig zusätzliche, redundante Bits aus der zu sendenden Bitfolge errechnet, die dem Signal hinzugefügt werden. Der Datenstrom auf dem Kanal erhöht sich dadurch, ohne daß mehr Nutzinformation übertragen wird. Auf der Seite des Empfängers werden die redundanten Bits genutzt, um eventuelle Übertragungsfehler erkennen und korrigieren zu können. Die redundante Information dient dazu, den Ort einer Störung und den erforderlichen Korrekturwert berechnen zu können. Je größer die Korrekturfähigkeit sein soll, desto mehr Redundanz muß für die Fehlerschutzverfahren eingefügt werden. In gleichem Maße sinkt bei vorgegebener Bandbreite die Nettoübertragungsrate des Kanals.

Deshalb wird üblicherweise versucht, die Redundanz möglichst klein zu halten. Aus der Literatur sind viele effiziente Verfahren zur Kanalcodierung bekannt.

Eine spezifische Klasse von Fehlerschutzverfahren bilden die sogenannten Reed-Solomon-Codes, wie sie beispielsweise aus dem Buch der Autoren Peterson und Weldon mit dem Titel "Error-Correcting Codes", MIT Press, Cambridge 1972, bekannt sind.

Reed-Solomon-Codes sind sogenannte Blockcodes. Das bedeutet, daß ein Block von Symbolen (häufig 8-Bit Symbole) gemeinsam verarbeitet wird. Der Block besitzt Datensymbole und zur Fehlerkorrektur hinzugefügte redundante Symbole (Parities). Ein Dimensionierungsbeispiel ist ein Code mit 8 Bit-Symbolen, einer Blocklänge von 255 Symbolen und einer Nettosymbolzahl pro Block von 239. Dann sind 16 Paritysymbole zur Fehlerkorrektur pro Block vorgesehen. Mit diesen 16 Symbolen können 8 Symbolfehler lokalisiert und korrigiert werden.

Aus B. Sklar: Digital Communications, Prentice Hall, 1988, ISBN 0-13-211939-0 025, Seiten 2 bis 9 und 314-338 ist ein System zur Übertragung von digitalen Signalen mit einem Kanalcodierer und einem Kanalmodulator auf der Senderseite und einem Kanaldemodulator und einem Kanaldecodierer auf der Empfangsseite bekannt, wobei es sich beim Kanaldecodierer um einen sogenannten "soft decision decoder" handelt. Dessen Aufgabe besteht darin, zwischen zwei Zuständen zu entscheiden. Dabei werden zur Decodierung mehr Bits verwendet als zur Symbolzuordnung erforderlich sind (3 Bits anstelle von 1 Bit). Diese zusätzlichen Bits liefern ein Vertrauensmaß, das in den Soft Decision-Algorithmus eingeht.

Auch aus J. Hagenauer und P. Hoher: "A Viterbi Algorithm with Soft-Decision Outputs and its Applications" in Proc. GLOBECOM 89, Dallas, Nov. 1989, Seiten 1680 bis 1686, ist ein derartiger Soft-Decision-Algorithmus bekannt.

Aus GB-A-2088676 ist ein Übertragungssystem bekannt, bei dem die zu übertragenden Daten gemeinsam mit zusätzlicher Information für eine Fehlerkorrektur an einen Empfänger übertragen werden. Die Daten werden in einem Codierer eines Sender codiert. Die übertragenen Daten werden beim Empfänger unter Verwendung von harten und weichen Entscheidungen decodiert, wodurch Fehler in den empfangenen Daten korrigiert werden können.

Aus EP-A-0524625 ist ein Verfahren zur Übertragung von HDTV (High Definition Television) -Signalen bekannt. Die Videosignale sind dabei in einzelne Blöcke aus PCM-Daten unterteilt. Die PCM-Daten werden weiter verarbeitet mit Bewegungsschätzung und Bewegungskompensation, so daß DPCM-Daten entstehen. Bei dem Verfahren wird darüberhinaus ein Reed-Solomon und Trellis-Codierer verwendet, deren codierte Ausgangsignale als QAM-Signale übertragen werden.

Der Erfindung liegt die Aufgabe zugrunde, ein System zur Übertragung und eine Vorrichtung zum Empfang von digitalen Fernsehsignalen mit verbesserter Fehlerkorrekturmöglichkeit anzugeben.

Diese Aufgabe wird durch ein System mit den im Anspruch 1 bzw. eine Vorrichtung mit den im Anspruch 6 angegebenen Merkmalen gelöst. Vorteilhafte Weiterbildungen ergeben sich aus den abhängigen Patentansprüchen.

Im folgenden wird die Erfindung anhand der Figuren 1 - 4 beispielhaft erläutert. Es zeigt

Figur 1    ein System zur Übertragung von digitalen Fernsehsignalen,

Figur 2    Diagramme zur Darstellung von Symbolen in der Zustandsebene,

Figur 3    ein Diagramm zur Erläuterung der Erzeugung von Informationen über die Zuverlässigkeit der Kanaldemodulation, und

Figur 4    ein System zur Übertragung von digitalen Fernsehsignalen unter Verwendung einer OFDM-Codierung.

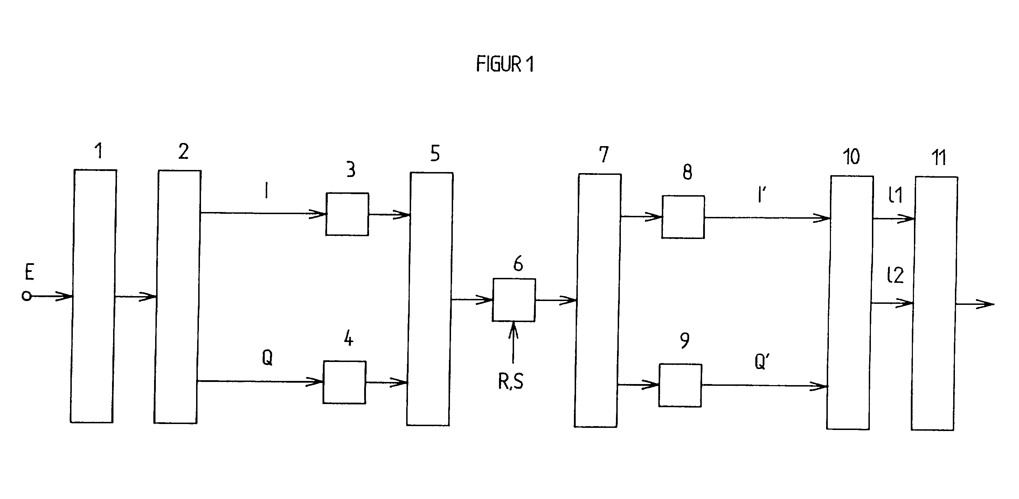

Die Figur 1 zeigt ein System zur Übertragung von digitalen Fernsehsignalen. Bei diesem System liegen die digitalisierten, gegebenenfalls quellencodierten Fernsehsignale am Eingang E in Form einer Bitfolge vor. In einem Kanalcodierer 1, bei dem es sich vorzugsweise um einen Reed-Solomon-Coder handelt, werden aus der zu sendenden Bitfolge zusätzliche, redundante Bits errechnet und der Bitfolge zugefügt. In einem empfangsseitigen Kanaldecodierer 11 werden diese redundanten Bits (Paritybits) zur Korrektur von Übertragungsfehlern verwendet.

Das Ausgangssignal des Kanalcodierers 1 wird einem digitalen Kanalmodulator 2, 3, 4, 5 zugeführt. In diesem werden zunächst in einem digitalen Modulator 2 mehrere Bits zu einem Modulationssymbol umgesetzt, das durch einen komplexen Wert (I, Q) definiert ist.

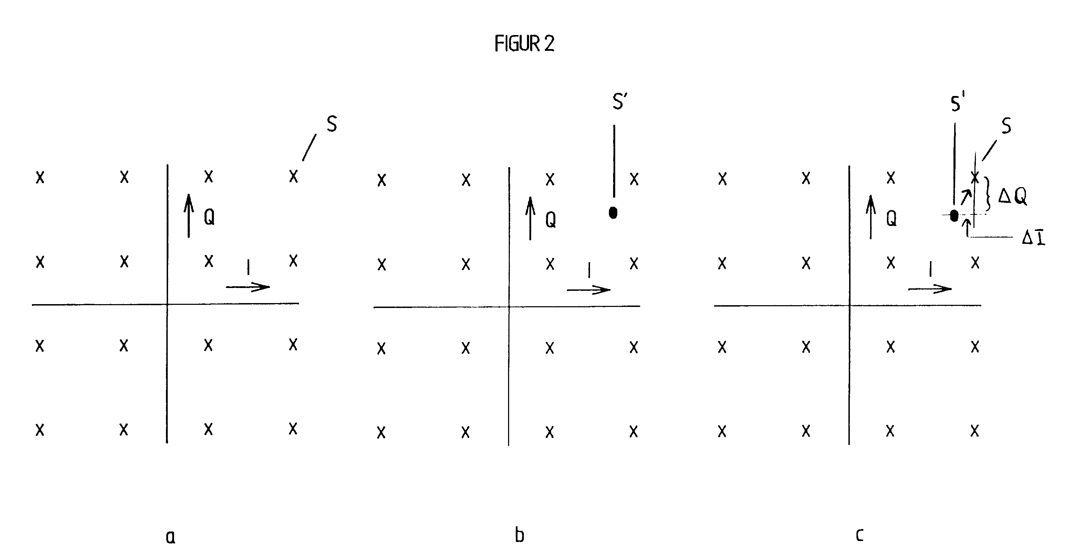

Die Figur 2a zeigt für das Ausführungsbeispiel einer 16 QAM alle möglichen Modulationssymbole in der Zustandsebene, d.h. alle Elemente des Modulationsalphabets. Mit S ist ein mögliches Sendesymbol bezeichnet.

Realteil I und Imaginärteil Q des komplexen Wertes werden in einem Digital-/Analog-Wandler 3 bzw. 4 in analoge Signale umgesetzt, aus welchen in einem Quadraturmodulator 5 ein kontinuierliches Sendesignal erzeugt wird.

Dieses wird über einen hochfrequenten Übertragungskanal 6 übertragen.

Empfangsseitig wird das Signal einem Kanaldemodulator 7, 8, 9, 10 zugeführt. Dort werden zunächst in einem Quadraturdemodulator 7 kontinuierliche Signale für den Real- und den Imaginärteil gewonnen. Diese werden in Analog-/Digital-Wandlern 8 bzw. 9 wieder in komplexe Werte (I', Q') umgewandelt. Da das Signal im Übertragungskanal Rauschen und anderen Störungen unterworfen ist, können sich die komplexen Werte I' und Q' von den senderseitig vorliegenden Werten I und Q unterscheiden, was einer Verschiebung der Lage des komplexen Symbols in der Zustandsebene bedeutet. Dies ist in Figur 2b gezeigt. S' stellt dabei das aufgrund der Störungen auf dem Kanal verschobene Empfangssymbol dar. Realteil I' und Imaginärteil Q' werden einem digitalen Demodulator 10 zugeführt. Dort erfolgt die Regenerierung des Bitstroms für die weitere Verarbeitung. Zusätzlich wird im digitalen Demodulator 10 eine Zuverlässigkeitsinformation erzeugt, wie unten noch erläutert wird.

Die Regenerierung des Bitstroms aus dem Realteil I' und dem Imaginärteil Q' geschieht unter Verwendung einer im digitalen Demodulator in einem Speicher, beispielsweise einem ROM, abgespeicherten Tabelle, welche Informationen über das Modulationsalphabet, d. h. über alle möglichen Modulationssymbole in der Zustandsebene, enthält.

Dazu wird in einer Rechenschaltung für jedes Empfangssymbol der Abstand zu den 4 benachbarten Elementen des Modulationsalphabets nach der Formel

$$a = \sqrt{\Delta\,I^2 + \Delta\,Q^2}$$

berechnet und dann das empfangene Symbol dem nächstliegenden Element des Modulationsalphabets zugeordnet. Diese Zuordnung ist in Figur 2c angedeutet, wobei mit S' das empfangene Symbol und mit S das nächstliegende Element des Modulationsalphabets bezeichnet sind.

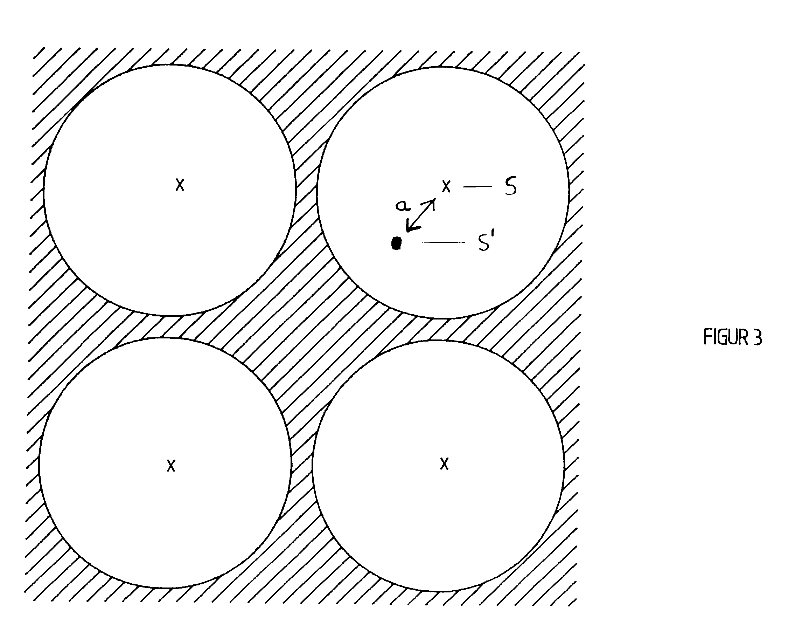

Der Abstand a zum nächstliegenden Element des Modulationsalphabets wird weiterhin als Maß für die Zuverlässigkeit der Übertragung verwendet. Dies ist in Figur 3 veranschaulicht.

Ist der Abstand a des empfangenen Symbols zum nächstliegenden Element des Modulationsalphabets größer als ein vorgegebener Schwellenwert $a_s$, wie es beispielsweise dann der Fall ist, wenn das empfangene Symbol in den schraffierten Bereichen von Figur 3 liegt, dann ist der Abstand des empfangenen Symbols von zwei oder mehreren Elementen des Modulationsalphabets in etwa gleich groß und die getroffene Zuordnung zu einem dieser Elemente möglicherweise fehlerhaft. Diese Überprüfung erfolgt unter Verwendung eines Vergleichers, in welchem der berechnete Wert a mit dem vorgegebenen Schwellenwert $a_s$ verglichen wird. Ergibt die Überprüfung, daß der berechnete Wert a größer ist als der vorgegebene Schwellenwert $a_s$, dann wird auf das Vorliegen einer unsicheren Demodulation erkannt.

Alternativ dazu ist es auch möglich, die schraffierte Fläche in Figur 3 in Form eines rechteckigen Gitters zu wählen.

Weiterhin können alternativ zu der oben beschriebenen Möglichkeit, den Abstand a rechnerisch zu ermitteln und mit einem Schwellenwert zu vergleichen, die gewünschten Informationen (nächstliegendes Element, Zuverlässigkeit der Demodulation) einer Festwertspeichertabelle entnommen werden, die mit den Abtastwerten für den Realteil I' und den Imaginärteil Q' adressiert wird.

Die unsichere Demodulation wird dem nachfolgenden Kanaldecodierer 11 über die Verbindung I1 in Form eines "Erasure-Flags" mitgeteilt. Dadurch erhält der Kanaldecodierer 11 vom digitalen Demodulator 10 neben der übertragenen Bitfolge, die über die Verbindung 12 übertragen wird und in welcher die Paritybits noch enthalten sind, zusätzlich Informationen über mögliche Fehlerorte. Damit kann der Kanaldecodierer 11, bei dem es sich vorzugsweise um einen Reed-Solomon-Decoder handelt, die Paritybits ausschließlich zur Fehlerkorrektur verwenden. Dadurch kann er mehr Fehler korrigieren als es möglich wäre, wenn einige der Paritybits zur Fehlererkennung verwendet werden müßten.

Nach einer vorteilhaften Weiterbildung der Erfindung erfolgt im digitalen Demodulator 10 eine Optimierung des Schwellenwertes $a_s$ nach statistischen Kriterien. Diese Optimierung des Schwellenwertes $a_s$ bedeutet eine Vergrößerung bzw. Verkleinerung der schraffierten Bereiche in Figur 3 und erfolgt derart, daß die Anzahl der dem Kanaldecodierer 11 zugeführten Erasure-Flags pro Signalblock die Fehlerkorrekturfähigkeit des Kanaldecoders 11 nicht übersteigt.

Dazu weist der digitale Demodulator 10 einen Zähler, welcher die Anzahl der Erasure-Flags pro Signalblock zählt, und einen Vergleicher auf, in welchem der jeweils aktuelle Zählwert mit einer Referenzzahl, die der Anzahl der pro Signalblock korrigierbaren Fehler entspricht, verglichen wird. Übersteigt der aktuelle Zählwert die Referenzzahl, dann wird der vorgegebene Schwellenwert vergrößert.

Weiterhin kann senderseitig als Fehlerschutz ein Faltungscode verwendet werden. Empfangsseitig erfolgt eine Auswertung unter Verwendung eines Trellisdecoders. Dabei wird in vorteilhafter Weise die Information über die Zuverlässigkeit der Kanalmodulation zur Steuerung der Metrik des Trellisdecoders verwendet.

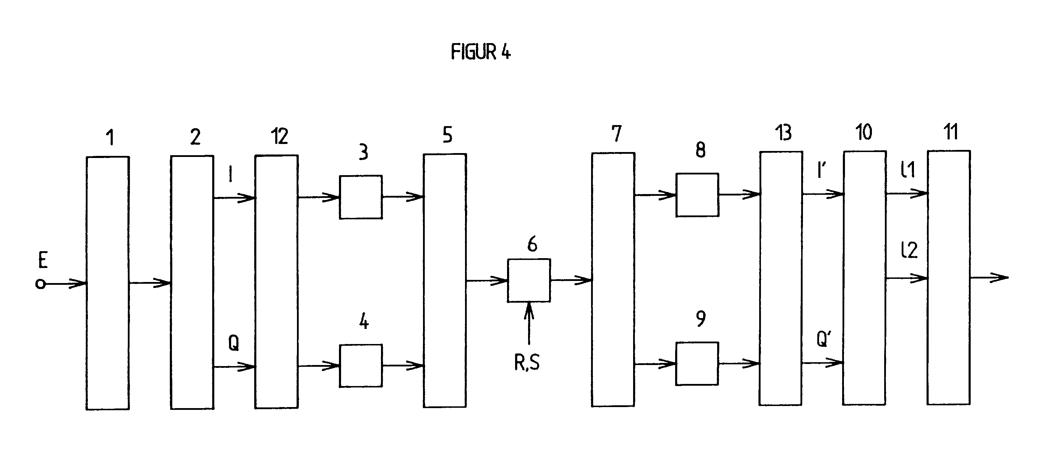

Die Figur 4 zeigt ein weiteres Ausführungsbeispiel für die Erfindung, bei der bei der Kanalmodulation das OFDM-Verfahren

(**O**rthogonal-**F**requenz-**D**ivision-**M**ultiplex-Verfahren) verwendet wird. Bei diesem Verfahren werden eine Vielzahl N von Unterträgern verwendet, beispielsweise 512, welche orthogonal zueinander sind. Weitere Einzelheiten zum OFDM-Verfahren können der bereits oben zitierten Literaturstelle Fernseh- und Kino-Technik, 46. Jg., Nr. 9/1992, °S. 559-570, entnommen werden.

Bei diesem Ausführungsbeispiel liegen die digitalisierten, gegebenenfalls quellencodierten Fernsehsignale - ebenso wie bei dem in Figur 1 gezeigten Ausführungsbeispiel - in Form einer Bitfolge vor. In einem Kanalcodierer 1 werden aus der zu sendenden Bitfolge zusätzliche, redundante Bits errechnet und der Bitfolge zugefügt. In einem empfangsseitigen Kanaldecodierer 11 werden diese redundanten Bits zur Korrektur von Übertragungsfehlern verwendet.

Das Ausgangssignal des Kanalcodierers 1 wird einem digitalen Kanalmodulator 2, 12, 3, 4, 5 zugeführt, In diesem werden zunächst in einem digitalen Modulator 2 mehrere Bits zu einem Modulationssymbol umgesetzt, das durch einen komplexen Wert (I, Q) definiert ist.

Real- und Imaginärteil dieses komplexen Wertes werden in einer Schaltung 12 einer inversen diskreten Fouriertransformation unterworfen und dann in einem Digital-/Analog-Wandler 3 bzw. 4 in analoge Signale umgesetzt, aus welchen in einem Quadraturmodulator 5 ein kontinuierliches Sendesignal erzeugt wird.

Dieses wird über einen hochfrequenten Übertragungskanal 6 übertragen.

Empfangsseitig wird das Signal einem Kanaldemodulator 7, 8, 9, 13, 10 zugeführt. Dort werden zunächst in einem Quadraturdemodulator 7 kontinuierliche Signale für den Real- und den Imaginärteil gewonnen. Diese werden in Analog-/Digital-Wandlern 8 bzw. 9 wieder in komplexe Werte (I', Q') umgewandelt. Diese werden in einer Schaltung 13 zur Bildung von Abtastwerten in der komplexen Ebene einer diskreten Fouriertransformation unterworfen und danach einem digitalen Demodulator 10 zugeführt. Dort erfolgt die Regenerierung des Bitstroms für die weitere Verarbeitung. Zusätzlich wird - ebenso wie es oben im Zusammenhang mit Figur 1 beschrieben wurde - im digitalen Demodulator 10 eine Zuverlässigkeitsinformation erzeugt, die dem Kanaldecodierer 11 zugeführt wird.

**Patentansprüche**

1. System zur Übertragung von digitalen Fernsehsignalen mit einem Kanalcodierer (1) und mit einem Kanalmodulator (2, 3, 4, 5) auf der Senderseite sowie mit einem Kanaldemodulator (7, 8, 9, 10) und einem Kanaldecodierer (11) auf der Empfangsseite, wobei im Kanaldemodulator (7, 8, 9, 10) Informationen (I1) über die Zuverlässigkeit der Kanaldemodulation ermittelt werden und diese Informationen (I1) dem Kanaldecodierer (11) zugeführt werden,
**dadurch gekennzeichnet,**
daß der Kanaldecodierer (11) ein Reed-Solomon-Decoder ist, daß die Informationen (I1) über die Zuverlässigkeit der Kanaldemodulation Erasure-Flags sind, die dem Reed-Solomon-Decoder als Informationen (I) über mögliche Fehlerorte zugeführt werden, und daß ein Erasure-Flag dann erzeugt wird, wenn der Abstand (a) eines Empfangssymbols zum nächstliegenden Element eines im Kanalmodulator (2, 3, 4, 5) verwendeten Modulationsalphabets größer als ein vorgegebener Schwellenwert ($a_s$) ist.

**2.** System nach Anspruch 1,
**dadurch gekennzeichnet,**
daß die Informationen (I1) über einen möglichen Fehlerort zusätzlich zur Zuordnung eines Empfangssymbols zum nächstliegenden Element des im Kanalmodulator (2, 3, 4, 5) verwendeten Modulationsalphabets verwendet werden.

**3.** System nach Anspruch 1,
**dadurch gekennzeichnet,**
daß die Zuordnung unter Verwendung einer empfangsseitig abgespeicherten Tabelle erfolgt, die Informationen über das im Kanalmodulator (2, 3, 4, 5) verwendete Modulationsalphabet enthält.

**4.** System nach einem der Ansprüche 1 bis 3,
**dadurch gekennzeichnet,**
daß der Schwellenwert ($a_s$).nach statistischen Kriterien optimiert wird.

**5.** System nach einem der Ansprüche 1 bis 4,
**dadurch gekennzeichnet,**
daß die Informationen (I1) über die Zuverlässigkeit der Kanaldemodulation einer Festwertspeichertabelle entnommen werden.

**6.** Vorrichtung zum Empfang von digitalen Fernsehsignalen mit einem Kanaldemodulator (7, 8, 9, 10) und einem Kanaldecodierer (11), wobei im Kanaldemodulator (7, 8, 9, 10) Informationen (I1) über die Zuverlässigkeit der Kanaldemodulation ermittelt werden und diese Informationen (I1) dem Kanaldecodierer (11) zugeführt werden,
**dadurch gekennzeichnet,**
daß der Kanaldecodierer (11) ein Reed-Solomon-Decoder ist, daß die Informationen (I1) über die Zuverlässigkeit der Kanaldemodulation Erasure-Flags sind, die dem Reed-Solomon-Decoder als Informationen (I) über mögliche Fehlerorte zugeführt werden, und daß ein Erasure-Flag dann erzeugt wird, wenn der Abstand (a) eines Empfangssymbols zum nächstliegenden Element eines im Kanalmodulator (2, 3, 4, 5) verwendeten Modulationsalphabets größer als ein vorgegebener Schwellenwert ($a_s$) ist.

**7.** Vorrichtung nach Anspruch 6,
**dadurch gekennzeichnet,**
daß der Kanaldemodulator (7, 8, 9, 10) weiterhin Mittel zur Zuordnung eines Empfangssymbols zum nächstliegenden Element des in einem Kanalmodulator (2, 3, 4, 5) verwendeten Modulationsalphabets aufweist, welche eingangsseitig mit den Mitteln zur Erzeugung von Informationen (I1) über die Zuverlässigkeit der Kanaldemodulation verbunden sind.

**8.** Vorrichtung nach Anspruch 7,
**dadurch gekennzeichnet,**
daß die Mittel zur Zuordnung eines Empfangssymbols zum nächstliegenden Element des im Kanalmodulator verwendeten Modulationsalphabets einen Speicher enthalten, in welchem Informationen über das Modulationsalphabet abgespeichert sind.

**9.** Vorrichtung nach einem oder mehreren der Ansprüche 6 bis 8,
**dadurch gekennzeichnet,**
daß die Mittel zur Erzeugung der Informationen (I1) über mögliche Fehlerorte eine Rechenschaltung zur Berechnung des Abstands eines Empfangssymbols zum nächstliegenden Element des Modulationsalphabets und einen Vergleicher enthalten, in welchem überprüft wird, ob der berechnete Abstand größer ist als ein vorgegebener Schwellenwert oder nicht.

**10.** Vorrichtung nach einem oder mehreren der Ansprüche 6 bis 9,
**dadurch gekennzeichnet,**
daß die Mittel zur Erzeugung von Informationen (I1) über mögliche Fehlerorte eine Festwerttabelle enthalten, der für jedes empfangene Symbol das zugehörige nächstliegende Element des Modulationsalphabets und die Information über mögliche Fehlerorte entnehmbar sind.

## Claims

**1.** System for transmitting digital television signals, comprising a channel encoder (1) and comprising a channel modulator (2, 3, 4, 5) at the transmitter end, and also comprising a channel demodulator (7, 8, 9, 10) and a channel decoder (11) at the reception end, items of information (I1) relating to the reliability of the channel demodulation being acquired in the channel demodulator (7, 8, 9, 10) and said items of information (I1) being fed to the channel decoder (11), characterized in that the channel decoder (11) is a Reed-Solomon decoder, in that the items of information (I1) relating to the reliability of the channel demodulation are erasure flags which are fed to the Reed-Solomon decoder as items of information (I) relating to possible error locations, and in that an erasure flag is generated if the distance (a) from a reception symbol to the nearest element of a modulation alphabet used in the channel modulator (2, 3, 4, 5) is greater than a specified threshold value ($a_s$).

**2.** System according to Claim 1, characterized in that the items of information (I1) relating to a possible error location are used in addition to the assignment of a reception symbol to the nearest element of the modulation alphabet used in the channel modulator (2, 3, 4, 5).

3. System according to Claim 1, characterized in that the assignment is carried out using a table which is stored at the reception end and which contains items of information relating to the modulation alphabet used in the channel modulator (2, 3, 4, 5).

4. System according to one of Claims 1 to 3, characterized in that the threshold value ($a_s$) is optimized according to statistical criteria.

5. System according to one of Claims 1 to 4, characterized in that the items of information (I1) relating to the reliability of the channel demodulation are taken from a read-only memory table.

6. Device for receiving digital television signals, comprising a channel demodulator (7, 8, 9, 10) and a channel decoder (11), items of information (I1) relating to the reliability of the channel demodulation being acquired in the channel demodulator (7, 8, 9, 10) and said items of information (I1) being fed to the channel decoder (11), characterized in that the channel decoder (11) is a Reed-Solomon decoder, in that the items of information (I1) relating to the reliability of the channel demodulation are erasure flags which are fed to the Reed-Solomon decoder as items of information (I) relating to possible error locations, and in that an erasure flag is generated if the distance (a) from a reception symbol to the nearest element of a modulation alphabet used in the channel modulator (2, 3, 4, 5) is greater than a specified threshold value ($a_s$).

7. Device according to Claim 6, characterized in that the channel demodulator (7, 8, 9, 10) furthermore comprises means for assigning a reception symbol to the nearest element of the modulation alphabet used in a channel modulator (2, 3, 4, 5), which means are connected on the input side to the means for generating items of information (I1) relating to the reliability of the channel demodulation.

8. Device according to Claim 7, characterized in that the means for assigning a reception symbol to the nearest element of the modulation alphabet used in the channel modulator comprise a memory in which items of information relating to the modulation alphabet are stored.

9. Device according to one or more of Claims 6 to 8, characterized in that the means for generating items of information (I1) relating to possible error locations comprise a computation circuit for calculating the distance from a reception symbol to the nearest element of the modulation alphabet and a comparator which checks whether the calculated distance is greater than a specified threshold value or not.

10. Device according to one or more of Claims 6 to 9, characterized in that the means for generating items of information (I1) relating to possible error locations contain a read-only table from which the appropriate nearest element of the modulation alphabet and the information relating to possible error locations can be taken for any received symbol.

**Revendications**

1. Système pour transmettre des signaux de télévision numériques comportant un codeur de canaux (1) et un modulateur de canaux (2,3,4,5) situés sur le côté émission ainsi qu'un démodulateur de canaux (7,8,9,10) et un décodeur de canaux (11), situés sur le côté réception, et dans lequel des informations (I1) concernant la fiabilité de la démodulation des canaux sont déterminées dans le démodulateur de canaux (7,8,9,10) et ces informations (I1) sont envoyées au décodeur de canaux (11), caractérisé en ce que le décodeur de canaux (11) est un décodeur Reed-Solomon, que les informations (I1) concernant la fiabilité de la démodulation des canaux sont des Erasure-Flags (drapeaux d'effacement), qui sont envoyés au décodeur Reed-Solomon en tant qu'informations (I) concernant des emplacements possibles d'erreurs et qu'un drapeau d'effacement est produit lorsque la distance (a) entre un symbole de réception et l'élément immédiatement suivant d'un alphabet de modulation utilisé dans le modulateur de canaux (2,3,4,5) est supérieure à une valeur de seuil ($a_s$) prédéterminée.

2. Système selon la revendication 1, caractérisé en ce que les informations (I1) concernant un emplacement possible d'erreur sont utilisées en plus de l'association d'un symbole de réception à l'élément immédiatement suivant de l'alphabet de modulation utilisé dans le modulateur de canaux (2,3,4,5).

3. Système selon la revendication 1, caractérisé en ce que l'association s'effectue moyennant l'utilisation d'un tableau mémorisé côté réception et qui contient des informations concernant l'alphabet de modulation utilisé dans le modulateur de canaux (2,3,4,5).

4. Système selon l'une des revendications 1 à 3, caractérisé en ce que la valeur de seuil ($a_s$) est optimisée selon des critères statistiques.

5. Système selon l'une des revendications 1 à 4, caractérisé en ce que les informations (I1) concernant la fiabilité de la modulation des canaux sont prélevées d'un tableau d'une mémoire morte.

6. Dispositif pour la réception de signaux de télévision numériques comportant un modulateur de canaux (7,8,9,10) et un décodeur de canaux (11), et dans lequel des informations (I1) concernant la fiabilité de la modulation sont déterminées dans le démodulateur de canaux (7,8,9,10) et ces informations (I1) sont envoyées au décodeur de canaux (11), caractérisé en ce que le décodeur de canaux (11) est un décodeur Reed-Solomon, que les informations (I1) concernant la fiabilité de la démodulation des canaux sont des Erasure-Flags (drapeaux d'effacement), qui sont envoyés au décodeur Reed-Solomon en tant qu'informations (I) concernant des emplacements possibles d'erreurs et qu'un drapeau d'effacement est produit lorsque la distance (a) entre un symbole de réception et l'élément immédiatement suivant d'un alphabet de modulation utilisé dans le modulateur de canaux (2,3,4,5) est supérieure à une valeur de seuil ($a_s$) prédéterminée.

7. Dispositif selon la revendication 6, caractérisé en ce que le démodulateur de canaux (7,8,9,10) comporte en outre des moyens pour associer un symbole de réception à l'élément immédiatement suivant de l'alphabet de modulation utilisé dans un modulateur de canaux (2,3,4,5), qui est relié, côté entrée, aux moyens de production d'informations (I1) concernant la fiabilité de la démodulation de canaux.

8. Dispositif selon la revendication 7, caractérisé en ce que les moyens d'association d'un symbole de réception à l'élément immédiatement suivant de l'alphabet de modulation utilisé dans le modulateur de canaux contiennent une mémoire, dans laquelle sont mémorisées des informations concernant l'alphabet de modulation.

9. Dispositif selon une ou plusieurs des revendications 6 à 8, caractérisé en ce que les moyens pour produire les informations (I1) concernant des emplacements possibles d'erreurs contiennent un circuit de calcul servant à calculer la distance entre un symbole de réception et l'élément immédiatement suivant de l'alphabet de modulation et un comparateur, dans lequel un contrôle est effectué pour déterminer si la distance calculée est supérieure ou non à une valeur de seuil prédéterminée.

10. Dispositif selon une ou plusieurs des revendications 6 à 9, caractérisé en ce que les moyens de production d'informations (I1) concernant des emplacements possibles d'erreurs contiennent un tableau de valeurs fixes, dans lequel peuvent être prélevés, pour chaque symbole reçu, l'élément immédiatement suivant associé de l'alphabet de modulation et les informations concernant des emplacements possibles d'erreurs.

FIGUR 1

FIGUR 2

a

b

c

EP 0 616 470 B1

FIGUR 3

FIGUR 4

EP 0 616 470 B1